(19) Europäisches Patentamt
European Patent Office
Office européen des brevets

(11) **EP 1 542 023 B1**

(12) **EUROPÄISCHE PATENTSCHRIFT**

(45) Veröffentlichungstag und Bekanntmachung des Hinweises auf die Patenterteilung:
**03.01.2007 Patentblatt 2007/01**

(51) Int Cl.:
***G01R 1/067*** *(2006.01)*

(21) Anmeldenummer: **05002153.4**

(22) Anmeldetag: **14.11.2002**

(54) **Fingertester**

Finger tester

Testeur à pattes

(84) Benannte Vertragsstaaten:
**AT BE BG CH CY CZ DE DK EE ES FI FR GB GR IE IT LI LU MC NL PT SE SK TR**

(30) Priorität: **07.12.2001 DE 10160119**

(43) Veröffentlichungstag der Anmeldung:
**15.06.2005 Patentblatt 2005/24**

(62) Dokumentnummer(n) der früheren Anmeldung(en) nach Art. 76 EPÜ:
**02792764.9 / 1 451 594**

(73) Patentinhaber: **atg test systems GmbH**
**97877 Wertheim/Reichholzheim (DE)**

(72) Erfinder: **Romanov, Victor**
**97877 Wertheim (DE)**

(74) Vertreter: **Ganahl, Bernhard et al**
**Huber & Schüssler**
**Patentanwälte**
**Truderinger Strasse 246**
**81825 München (DE)**

(56) Entgegenhaltungen:
| | |
|---|---|
| **EP-A- 0 460 911** | **EP-A- 0 660 387** |
| **US-A- 3 648 169** | **US-A- 4 123 706** |
| **US-A- 5 804 982** | |

**Beschreibung**

Die Erfindung betrifft einen Fingertester zum Testen von unbestückten Leiterplatten.

Prüfvorrichtungen zum Testen von Leiterplatten können grundsätzlich in zwei Gruppen eingeteilt werden, der Gruppe der Fingertester und der Gruppe der Paralleltester. Die Paralleltester sind Prüfvorrichtungen, die mittels eines Adapters alle oder zumindest die meisten Kontaktstellen einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequentiell abtasten.

Beim Prüfen von unbestückten Leiterplatten müssen im Vergleich zum Prüfen mit bestückten Leiterplatten, dem In-Circuit-Testing, wesentlich mehr Leiterplattentestpunkte kontaktiert werden, weshalb das wesentliche Kriterium für eine erfolgreiche Vermarktbarkeit eines Fingertesters für unbestückte Leiterplatten der Durchsatz an kontaktierten Leiterplattentestpunkten innerhalb einer vorbestimmten Zeit ist.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Zum Kontaktieren einer Kontaktstelle einer zu prüfenden Leiterplatte ist der Schlitten an der Traverse vertikal verschieblich, so dass der Prüffinger von oben bzw. von unten auf die Kontaktstelle der Leiterplatten gesetzt werden kann.

Ein Fingertester ist in der EP 0 468 153 A1 und ein Verfahren zum Prüfen von Leiterplatten mittels eines Fingertesters ist in der EP 0 853 242 A1 beschrieben. Aus der EP 0 990 912 A geht eine Prüfsonde für einen Fingertester hervor, bei welcher eine Prüfnadel derart beweglich geführt ist, dass sie aus der Prüfsonde zum Kontaktieren eines Leiterplattentestpunktes herausgefahren werden kann. Wird ein Leiterplattentestpunkt kontaktiert, so kann die Prüfnadel seitlich auslenken, wodurch die mechanische Belastung auf den Leiterplattentestpunkt begrenzt wird. Die Prüfnadel wird hierbei durch einen elektromagnetischen Antrieb angetrieben. Weiterhin sind Prüfsonden bekannt, bei welchen eine gefederte Prüfnadel verwendet wird. Bei senkrechter Anordnung der Prüfnadel bzgl. der zu testenden Leiterplatte besteht der Nachteil, dass zwei eng nebeneinander liegende Leiterplattentestpunkte nicht kontaktierbar sind, da aufgrund der Größe der gefederten Prüfnadeln diese mit ihren Prüfspitzen nicht beliebig eng aneinander angeordnet werden können.

Zur Vermeidung dieses Nachteiles hat man die Prüfnadel in einer entsprechenden Testvorrichtung schräg bzgl. der zu testenden Leiterplatte angeordnet. Hierdurch ist es möglich, zwei Prüfnadeln mit ihren Prüfspitzen sehr eng nebeneinander anzuordnen. Dies hat jedoch den Nachteil, dass beim Einfedern der federnden Prüfnadeln die Prüfspitze entlang der Oberfläche der zu testenden Leiterplatte bewegt wird, wodurch bei hohen Kontaktgeschwindigkeiten ein Kratzer auf der Leiterplatte erzeugt werden kann. Zudem wird durch die Schrägstellung der Prüfnadel der Ort, an welcher die Leiterplatte kontaktiert wird, ungenau, da die Prüfspitze parallel zu der Oberfläche der Leiterplatte bewegt wird.

Zur Vermeidung dieser Probleme hat man Prüfsonden entwickelt, die einen relativ langen, horizontal angeordneten Federarm aufweisen, an dessen Ende die Prüfnadel ausgebildet ist. An diesem langen Federarm ist vorteilhaft, dass eine Auslenkung um einen kleinen Winkel bereits einen relativ großen Federweg erzeugt. Hierdurch kann die Bewegung parallel zur Oberfläche der zu testenden Leiterplatte gering gehalten aber nicht vollständig vermieden werden. Auch bei einer solchen Prüfsonde besteht die Gefahr, dass die Oberfläche einer zu prüfenden Leiterplatte verkratzt wird. Zudem ist durch die Größe des Federarmes die Prüfsonde relativ schwer, wodurch beim Aufsetzen der Prüfspitze auf die Leiterplatte mit hoher Geschwindigkeit diese beschädigt werden kann. Zur Verminderung derartiger Beschädigungen wird im Bereich des Federarmes eine Lichtschranke vorgesehen, mit welcher eine Auslenkung des Federarmes detektierbar ist. Bei einer Auslenkung des Federarmes wird die Bewegung der Prüfsonde abgebremst, so dass eine weitere Beschädigung der Leiterplatte möglichst vermieden werden soll.

Aufgrund der beträchtlichen Größe des Federarmes ist es sehr aufwendig diesen gegenüber elektrischer Strahlung abzuschirmen, was bei Messungen mit Hochfrequenzsignalen zweckmäßig ist.

Eine weitere bekannte Prüfsonde weist als Prüfnadel eine Starrnadel auf, die mittels eines Parallellenkers an einer Halterung befestigt ist. Der Parallellenker besteht aus zwei aus Kunststoff ausgebildeten Haltearmen, die mit einem Ende an einer Halterung befestigt sind, und am anderen Ende der Haltearme ist die Starrnadel angeordnet. Diese Nadel kann bei einer Schwenkbewegung des Parallellenkers vertikal nach oben bewegt werden. Ein die Prüfspitze tragender Endbereich der Prüfnadel ist gegenüber dem übrigen Abschnitt der Prüfnadel abgewinkelt, so dass die Prüfspitze an der Prüfsonde etwas vorsteht. Hierdurch können zwei eng beieinander liegende Leiterplattentestpunkte mit zwei Prüfsonden kontaktiert werden. Die Haltearme des Parallellenkers sind derart bemessen, dass eine möglichst geringe Bewegung parallel zur Oberfläche der Leiterplatte bei einer Schwenkbewegung des Parallellenkers auftritt.

Nachteilig bei dieser Prüfsonde ist, dass das Kabel, das zur Zuführung des Messsignales dient und das an der Prüfnadel befestigt ist, durch seine Festigkeit und Masse beim schnellen Auftreffen der Prüfsonde auf eine Leiterplatte einen erheblichen Impuls verursacht, der zu Beschädigungen der zu testenden Leiterplatte führen kann. Dies gilt insbesondere bei einer Ausführungsform, bei welcher an einem Parallellenker zwei Prüfnadeln befestigt sind, an welchen jeweils ein Kabel befestigt ist, um eine 4-Draht-Messung durchführen zu können.

Aus der US 5,804,982 geht eine Prüfsonde zum Testen von Kontaktstellen integrierter Schaltkreise hervor. Diese Prüfsonde besitzt zwei elastische Haltearme, die mit einem Ende an einem Rahmen einer Prüfvorrichtung befestigt sind. Die beiden Haltearme sind zueinander parallel angeordnet und weisen an ihrem, vom Rahmen entfernten Ende, einen nicht-magnetischen Körper auf, der zwischen den beiden Endpunkten der Haltearme angeordnet ist. Im unteren Bereich des Körpers ist eine Prüfnadel angeordnet. Zwischen den Haltearmen sind Magnetspulen vorgesehen, die mit einem weiteren Magneten derart zusammen wirken, dass sie die Haltearme mit einer vertikal nach unten gerichteten Kraft beaufschlagen können.

Ein Kontaktpunkt eines integrierten Schaltkreises wird mittels dieser Prüfsonde durch Erregen der in der Prüfsonde angeordneten Magnetspulen kontaktiert, so dass die Prüfnadel auf die Kontaktstelle zubewegt wird.

Die WO 96/24069 betrifft eine Vorrichtung zum Testen von Flachbaugruppen (In-Circuit-Test). Die Prüfsonde dieser Vorrichtung weist eine schwenkbare Prüfnadel auf, die mit einem Ende die Testpunkte der Flachbaugruppe kontaktiert und am anderen Ende eine Bewegungsmimik zum Schwenken der Prüfnadel besitzt.

Aus der US 4,123,706 geht eine Prüfsonde mit einem oberen und einem unteren elastischen Haltearm zum Halten einer Prüfnadel hervor. Die beiden Prüfarme bestehen aus einem sich in der Draufsicht hin zur Prüfnadel verjüngenden Blechstreifen. Die Haltearme sind elektrisch leitend und elektrisch mit der Prüfnadel verbunden, so dass Messsignale über die Haltearme geleitet werden können. Diese Prüfsonde wird zum Testen von Halbleiterschaltungen verwendet.

Die US 3,648,169 zeigt eine weitere Prüfsonde zum Testen von Halbleiterschaltungen. Diese Prüfsonde weist ein Sondenelement auf, das als dünnes Plättchen ausgebildet ist. In diesem Plättchen ist eine rechteckförmige Öffnung eingebracht, die zwei Arme begrenzt, die somit integral im Körper des Sondenelementes ausgebildet sind. Diese Arme erlauben ein vertikales Ausweichen einer Sondenspitze, wobei ein Kratzen auf der Oberfläche des zu testenden Gegenstandes minimal sein soll.

Aus der EP 0 660 387 A2 geht eine Sonde zum Testen von Halbleiterbauelementen hervor, die eine mittels elastischer Arme gehaltene Prüfnadel aufweist.

Die EP 0 460 911 A2 zeigt eine Prüfsonde, mit welcher eine Sondenspitzenanordnung mittels zweier paralleler Federarme nach oben und nach unten biegsam an einer Sondenhalterung befestigt ist.

Der Erfindung liegt die Aufgabe zugrunde, einen Fingertester zum Testen von unbestückten Leiterplatten zu schaffen, wobei die Prüfsonde mit hoher Geschwindigkeit mit der zu testenden Leiterplatte in Kontakt gebracht werden kann und dennoch keine Beschädigung der Leiterplatte verursacht wird.

Die Erfindung wird durch einen Fingertester mit den Merkmalen des Anspruchs 1 gelöst. Vorteilhafte Ausgestaltungen der Erfindung sind in den Unteransprüchen angegeben.

Der erfindungsgemäße Fingertester zum Testen von unbestückten Leiterplatten umfasst einen Linearmotor mit zwei einander gegenüberliegend angeordneten, statischen Magnetflusskörpern und einer dazwischen angeordneten, beweglichen Ankerplatte, die aus einem nicht-magnetischen Material ausgebildet ist und in regelmäßigen Abständen streifenförmige Ankerelemente aufweist, die aus einem magnetischen Material ausgebildet sind, wobei an der Ankerplatte eine erfindungsgemäße Prüfsonde, die keinen eigenen Antrieb aufweist, und mit einer Prüfnadel, die mit einer Prüfspitze mit einem Leiterplattentestpunkt in Kontakt bringbar ist, und mittels zumindest zweier elastisch federnder Haltearme schwenkbar an einer Halterung befestigt ist, angeordnet ist, und zumindest einer der Haltearme aus einem elektrisch leitenden Material ausgebildet und mit der Prüfnadel elektrisch verbunden ist.

Die Kombination der erfindungsgemäßen Prüfsonde mit einem Linearmotor, der eine bewegliche Ankerplatte aufweist, die sehr leicht ausbildbar ist, erlaubt eine drastische Steigerung des Durchsatzes zum Kontaktieren von Leiterplattentestpunkten im Vergleich zu bekannten Fingertestern, da lediglich geringe Massen beschleunigt werden müssen und beim Auftreffen der Prüfspitze auf den Leiterplattentestpunkt zudem der Impuls durch die Prüfsonde abgefedert wird.

Bei einem Fingertester mit einer solchen Prüfsonde kann das Messsignal über den elektrisch leitenden Haltearm der Prüfnadel zugeführt werden. Die Prüfnadel ist somit mit keinem Kabel verbunden, das beim Auftreffen der Prüfsonde auf einer zu testenden Leiterplatte einen Impuls verursachen würde. Beim Auftreffen der Prüfsonde auf der Leiterplatte wird hingegen lediglich die Prüfnadel an dem Parallellenker gegenüber der Halterung bewegt, so dass die auf der Leiterplatte ausgeübte Kraft sich alleine aus dem Bewegungsimpuls der Prüfnadel und der durch die Haltearme ausgeübten Federkraft zusammensetzt. Der Impuls der Prüfnadel ist durch die geringe Masse der Prüfnadel sehr gering. Gleiches gilt für die von den Haltearmen ausgeübte Federkraft.

Mit dieser Prüfsonde wird beim Kontaktieren — auch bei schneller Bewegung der Sonde - der Leiterplatte somit eine geringe, präzise definierte Kontaktkraft ausgeübt.

Nach einer bevorzugten Ausführungsform sind zumindest zwei Haltearme aus einem elektrisch leitenden Material ausgebildet und mit der Prüfnadel elektrisch verbunden. Dies erlaubt eine 4-Draht-Messung.

Nach einer weiteren bevorzugten Ausführungsform der Erfindung sind zwei Paar Haltearme vorgesehen wobei jedes Paar Haltearme in einer Ebene angeordnet ist und mit einem Ende an der Prüfnadel und mit dem anderen Ende an der Halterung befestigt sind und in der Draufsicht spannt jedes Paar Haltearme ein Dreieck auf. Eine derartige Ausbildung mit vier Haltearmen erlaubt zum Einen die Durchführung einer 4-Draht-Messung mittels zweier der vier Haltearme und die elektrische Kontaktierung eines Abschirmelementes mittels eines weiteren Haltearmes. Zudem ist an dieser räumlichen Ausbildung der Haltearme von Vorteil, dass die Prüfnadel sehr stabil und definiert an der Halterung gehalten wird.

Die Haltearme des Parallellenkers sind vorzugsweise so bemessen, dass die Prüfnadel in einer schrägen Stellung gegenüber der zu testenden Leiterplatte gehalten wird und dennoch bei einer Schwenkbewegung der Prüfnadel die Prüfspitze keine oder nur eine äußerst geringe Bewegung parallel zur Oberfläche der zu testenden Leiterplatte ausführt.

Die Erfindung wird nachfolgend anhand den in den Zeichnungen gezeigten Ausführungsbeispielen näher erläutert. In den Zeichnungen zeigen:

Fig. 1      eine erstes Ausführungsbeispiel einer erfindungsgemäßen Prüfsonde in perspektivischer Ansicht,
Fig. 2      die Prüfsonde aus Fig. 1, wobei die Prüfnadel sowohl in der Ausgangsstellung als auch in ausgelenkten Stellungen gezeigt ist,
Fig. 3      ein zweites Ausführungsbeispiel einer erfindungsgemäßen Prüfsonde in perspektivischer Ansicht,
Fig. 4      die Prüfsonde aus Fig. 3 in einer Ansicht, bei der die einzelnen Elemente transparent dargestellt sind,
Fig. 5      ein drittes Ausführungsbeispiel einer erfindungsgemäßen Prüfsonde in perspektivischer Ansicht,
Fig. 6      die Prüfsonde aus Fig. 5 ohne Gehäuse in perspektivischer Ansicht,
Fig. 7      schematisch eine erfindungsgemäße Prüfsonde in der Seitenansicht mit Abmessungen,
Fig. 8      ein schematisch vereinfachtes Schaltbild einer 4-Draht-Messung mit zwei erfindungsgemäßen Prüfsonden,
Fig. 9      eine schematische Darstellung einer ersten Ausführungsform eines Linearmotors,
Fig. 10     eine schematische Darstellung einer zweiten Ausführungsform eines Linearmotors,
Fig. 11     eine schematische Darstellung einer dritten Ausführungsform eines Linearmotors,
Fig. 12     eine Prüfsonde schematisch in einer Seitenansicht, und
Fig. 13     schematisch einen erfindungsgemäßen Fingertester in perspektivischer Ansicht.

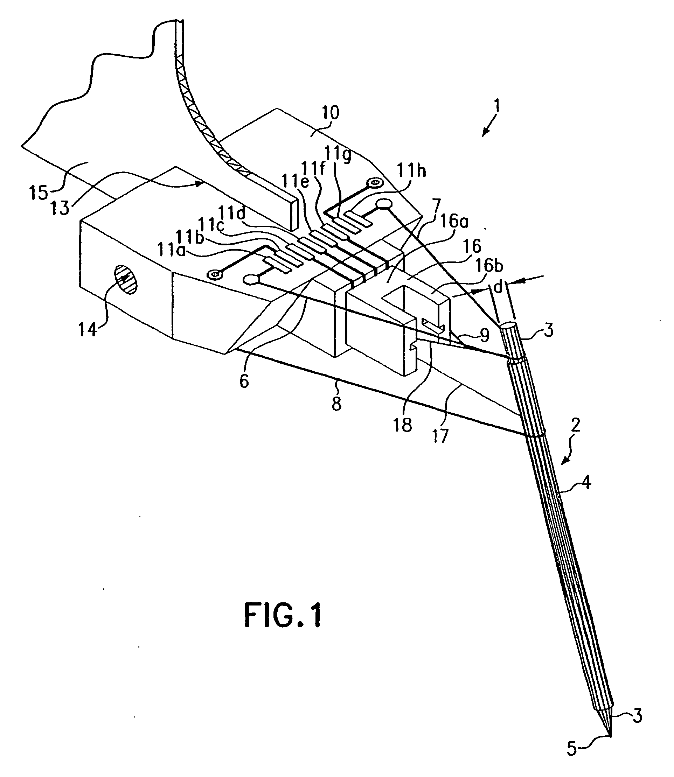

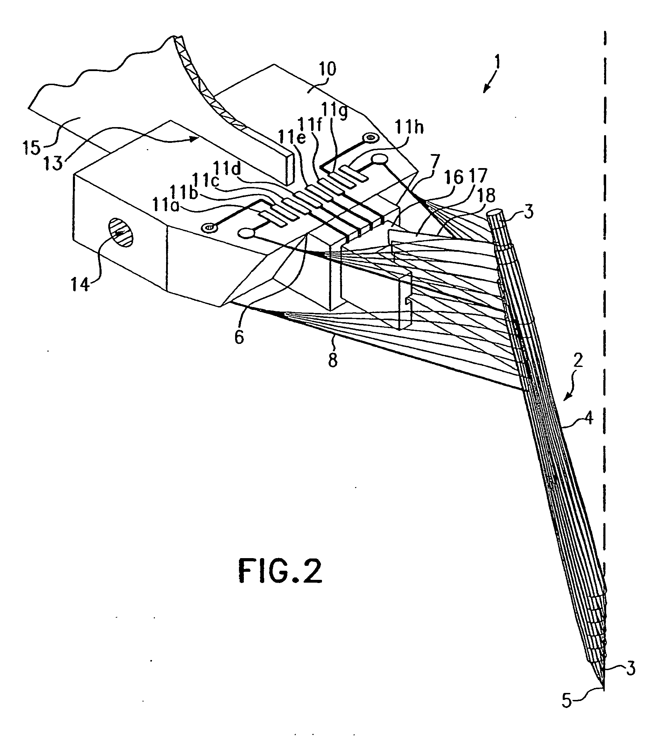

Die Figuren 1 und 2 zeigen eine erste Ausführungsform einer Prüfsonde 1. Die Prüfsonde weist eine Prüfnadel 2 auf, die in der vorliegenden Ausführungsform aus einer Nadel 3 mit einem Durchmesser d von 0,3 bis 0,5 mm ausgebildet ist. Die Nadel 3 besteht z.B. aus Stahl oder Wolfram. Die Nadel 3 ist mit einer Isolationsschicht ummantelt, die z.B. aus Teflon ausgebildet ist. Die Ummantelung ist wiederum mit einer elektrisch leitenden Schicht beschichtet. Diese Ummantelung mit der elektrisch leitenden Schicht bildet eine Abschirmung 4, die die Nadel 3 vor elektrischen Feldern abschirmt. Die Nadel 3 steht mit beiden Enden an der Abschirmung 4 vor, wobei eines der beiden Enden spitz zulaufend zur Ausbildung einer Prüfspitze 5 ausgebildet ist. An dem der Prüfspitze gegenüber liegendem Ende ist die Prüfnadel 2 bzw. die Nadel 3 mit zwei Haltearmen 6, 7 verbunden, die im nachfolgenden als obere Haltearme bezeichnet werden. Zwei weitere Haltearme 8, 9 sind ein Stück beabstandet von der Verbindungsstelle zwischen den oberen Haltearmen 6, 7 und der Prüfnadel 2 an der Abschirmung 4 befestigt. Die Haltearme 8, 9 werden nachfolgend als untere Haltearme bezeichnet. Die beiden Paar Haltearme 6, 7 bzw. 8, 9 sind jeweils aus einem Drahtstück ausgebildet, das in der Mitte abgebogen ist, wobei an der Biegungsstelle die Prüfnadel 2 mittels einer elektrisch leitenden Verbindung, wie z.B. einer Lötverbindung, befestigt ist. Die beiden Paare Haltearme 6, 7 bzw. 8, 9 bilden somit jeweils ein gleichschenkliges Dreieck, wobei sich in der Spitze des gleichschenkligen Dreiecks die Prüfnadel 2 befindet.

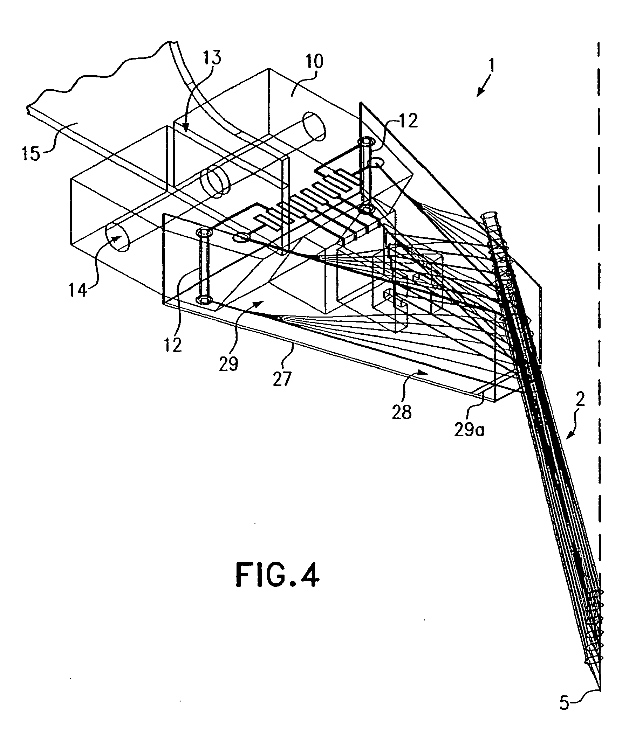

Die Haltearme 6 bis 9 sind mit ihren von der Prüfnadel 2 entfernten Enden an einer Halterung 10 befestigt. Die Halterung 10 ist ein elektrisch isolierendes Kunststoffteil, das an der Oberseite mit einer Reihe von Kontaktflächen 11 a bis 11 h versehen ist. Die oberen Haltearme 6, 7 sind jeweils über Leiterbahnen mit der Kontaktfläche 11a bzw. 11 h elektrisch verbunden. Die unteren Haltearme 8, 9 sind jeweils über einen sich vertikal durch die Halterung 10 erstreckenden elektrisch leitenden Metallstift 12 (Fig. 4) und einer Leiterbahn mit der Kontaktfläche 11 b bzw. 11 g elektrisch verbunden.

Diese Kontaktflächen 11a bis 11 h sind über weitere Leiterbahnen (nicht dargestellt) mit einer an der Halterung 10 ausgebildeten elektrischen Steckverbindung (nicht dargestellt) verbunden. Die Halterung 10 ist als Steckelement ausgebildet, das an einem Prüfkopf eines Fingertesters steckbar ist. Beim vorliegenden Ausführungsbeispiel weist die Halterung 10 eine Schlitz 13 auf, der an der von der Prüfnadel 2 entfernt angeordneten Seitenfläche der Halterung 10 mündet. Zudem weist die Halterung 10 eine Bohrung 14 auf, die quer zum Schlitz 13 angeordnet ist. Die Halterung 10 kann somit mit dem Schlitz auf eine dünne Wandung 15 des Prüfkopfs aufgeschoben und mittels eines die Bohrung 14 der Halterung und eine korrespondierende Bohrung in der Wandung 15 durchsetzenden Stiftes fixiert werden. Beim Aufschieben bzw. -stecken der Halterung 10 auf die Wandung 15 des Prüfkopfes werden gleichzeitig die mit den Kontaktfläche 11a bis 11h verbundenen Leiterbahnen mit korrespondierenden Leiterbahnen des Prüfkopfes elektrisch verbunden.

An der Halterung 10 ist an der zur Prüfnadel 2 benachbart angeordneten Seitenfläche ein Lichtschranken-Element 16 angeordnet. Das Lichtschranken-Element 16 ist in der Draufsicht U-förmig mit einer Basis 16a und zwei Schenkeln 16b ausgebildet. An einem der beiden Schenkel 16b ist innenseitig an seinem Endbereich eine Lichtquelle angeordnet und an dem anderen Schenkel 16b ist ein das Lichtsignal empfangender Lichtsensor angeordnet. Die Lichtquelle und der Lichtsensor bilden somit eine Lichtmessstrecke. Die Lichtquelle und der Lichtsensor weisen in der horizontalen Ebene eine gewisse Längserstreckung auf, die z.B. 1 mm beträgt. An der Prüfnadel 2 ist eine Messfahne 17 befestigt, die z.B. aus einem dünnen Metallblech ausgebildet ist. Diese Messfahne liegt in einer Längsmittenebene der Prüfsonde 1, die vertikal angeordnet ist und die Spiegelebene zu den Haltearmen 6 und 7 bzw. 8 und 9 bildet. Die obere Kante der Messfahne 17 ist als Messkante 18 ausgebildet und verläuft in der in Fig. 1 gezeigten Ausgangsstellung, bei der die Haltearme 6 bis 9 geradlinig verlaufen, schräg bzgl. einer horizontalen Ebene und ist unmittelbar unterhalb der Lichtmessstrecke angeordnet.

Beim Aufsetzen der Prüfsonde 1 auf eine zu testende Leiterplatte wird die Prüfnadel 2 mit einer Kraft beaufschlagt, wodurch die Haltearme aus der Ausgangsstellung in eine ausgelenkte Stellung (nach oben in Fig. 1 und 2) geschwenkt werden. Hierdurch wird die Messfahne 18 in die Lichtmessstrecke eingeführt. Durch das Vorsehen der schrägen Messkante 18 wird die Lichtmessstrecke proportional zum Bewegungsweg der Prüfnadel gegenüber der Halterung 10 unterbrochen, so dass das mit der Lichtschranke gemessene Signal proportional zum Bewegungsweg der Prüfnadel ist.

Das Lichtschranken-Element 16 ist über vier Leiterbahnen jeweils mit einer der Kontaktflächen 11c bis 11f verbunden, die gleichermaßen wie die übrigen Kontaktflächen mittels einer elektrischen Steckverbindung mit dem Prüfkopf verbunden sind.

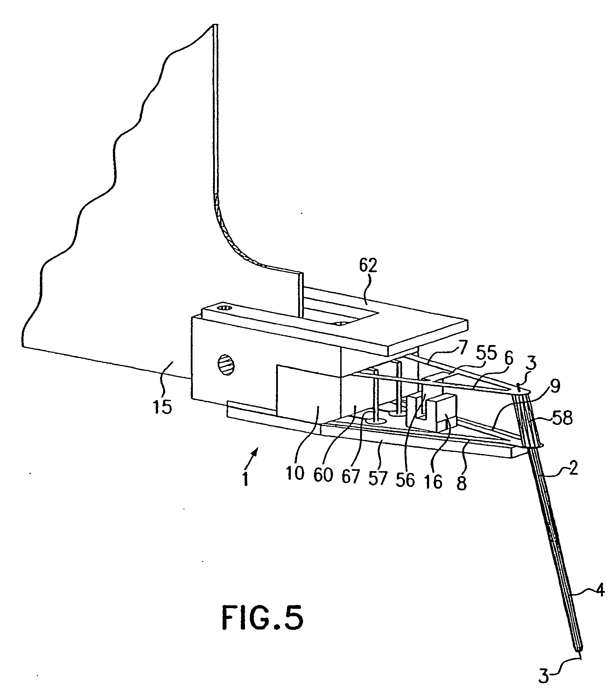

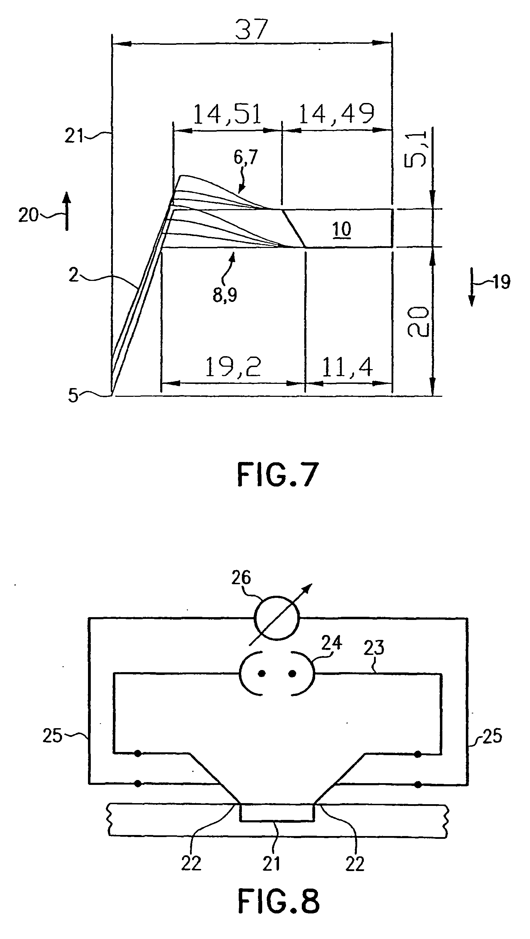

Fig. 7 zeigt schematisch die erfindungsgemäße Prüfsonde 1 in einer Seitenansicht mit der Halterung 10 und den oberen bzw. unteren Haltearmen 6, 7 bzw. 8, 9 und der Prüfnadel 2. Beim in-Berührung-Bringen der Prüfsonde 1 mit einer zu testenden Leiterplatte wird die Prüfsonde 1 mit der Prüfspitze 5 auf die Leiterplatte (Richtung 19) aufgesetzt. Die Prüfnadel 2 wird hierbei bezüglich der Halterung 10 in Richtung des Pfeils 20 (nach oben in Fig. 5) bewegt. Diese Richtung 20 wird nachfolgend als Bewegungsrichtung 20 der Prüfnadel 2 bezeichnet. Die oberen und unteren Haltearme 6, 7 und 8, 9 bilden in der Seitenansicht zusammen mit der entsprechenden Begrenzungskante der Halterung 10 und den zwischen den oberen und unteren Haltearmen angeordneten Abschnitt der Prüfnadel 2 ein Trapez. Die Längen der einzelnen Abschnitte, die in Fig. 7 in Millimeter angegeben sind, sind derart bemessen, dass beim Bewegen der Prüfnadel 2 die Prüfspitze 5 über einen gewissen Weg, von z.B. 5 mm, entlang einer geraden Linie 21 bewegt wird, die senkrecht zu den Ebenen steht, die durch die oberen Haltearme bzw. unteren Haltearme in ihrer Ausgangsstellung aufgespannt werden.

Da die Richtung 19, in welcher die Prüfsonde 1 auf die Leiterplatte zubewegt wird exakt entgegengesetzt zur Bewegungsrichtung 20 der Prüfnadel bzgl. der Halterung 10 ist und die Prüfspitze entlang einer geraden Linie parallel zur Bewegungsrichtung 20 bewegt wird, wird keine Bewegungskomponente parallel zur Oberfläche der zu testenden Leiterplatte erzeugt, wodurch sichergestellt ist, dass die Prüfspitze 5 die Oberfläche der Leiterplatte nicht verkratzt. Die Prüfspitze wird somit beim Aufsetzen der Prüfsonde auf dem Prüfling nicht bewegt.

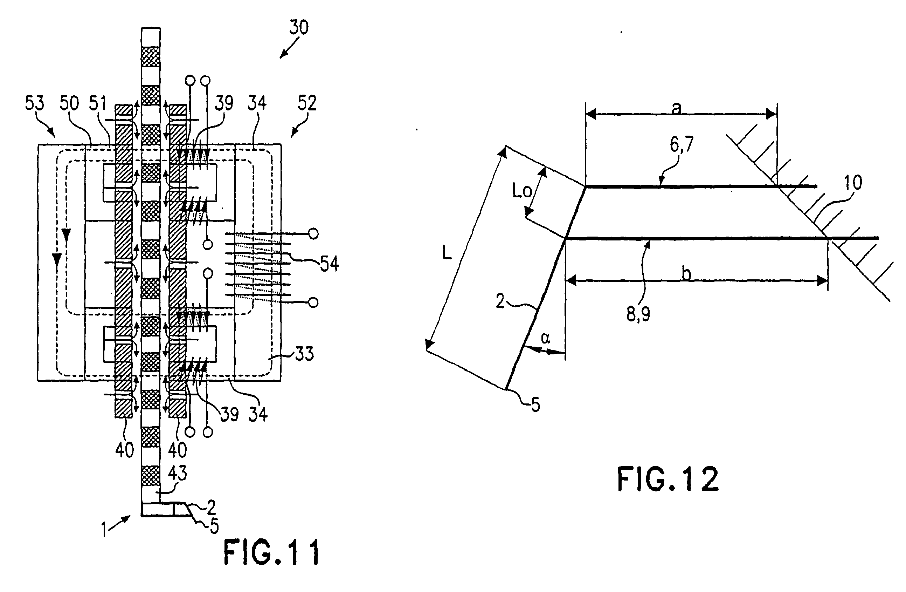

Fig. 12 zeigt die Trapezanordnung der Prüfsonde schematisch in einer Seitenansicht, wobei die Länge der oberen Haltearme 6, 7 in der Seitenansicht mit der Variable a, die Länge der unteren Haltearme 8, 9 mit der Variable b, die Länge der Prüfnadel 2 mit der Variable L und die Länge des Abschnittes der Prüfnadel 2 zwischen den oberen und den unteren Haltearmen mit der Variable $L_0$ bezeichnet werden. Bei der in Fig. 12 gezeigten Anordnung wird die Prüfspitze beim Aufsetzen der Prüfnadel nicht bewegt, wenn diese Längenangaben etwa folgende Formel erfüllen:

$$a \approx b\left(1 - \tan\frac{L_0}{L}\right)^{-}$$

Diese Formel gilt für den Winkelbereich von $0 \le \alpha < \frac{\pi}{2}$.

Diese Formel kann auch durch folgende Reihenentwicklung dargestellt werden:

$$a \approx b\left(1 - \frac{L_0}{L} - \frac{1}{3}\left(\frac{L_0}{L}\right)^3 - \frac{2}{15}\left(\frac{L_0}{L}\right)^5 - \ldots\ldots\right)$$

5

Für kleine Bewegungen der Prüfsonde kann diese Formel folgendermaßen vereinfacht werden:

$$a \approx b\left(1 - \frac{L_0}{L}\right)$$

Die oben angegebenen Formel beschreiben somit eine Ausführungsform, bei welcher die Prüfspitze im wesentlichen vertikal bewegt wird. Dies gilt für die in Fig. 12 gezeigte Trapezanordnung.

Beim Aufsetzen der Prüfsonde 1 wird, wie man es anhand von Fig. 2 und 7 erkennen kann, die Prüfnadel 2 bzgl. der Halterung 10 aus der in Fig. 1 gezeigten Ausgangsstellung elastisch in Bewegungsrichtung 20 ausgelenkt, wobei die Haltearme 6 bis 9 als elastische Federelemente wirken. Dies hat zur Folge, dass beim Aufsetzen der Prüfsonde 1 auf eine zu testende Leiterplatte lediglich der Bewegungsimpuls der Prüfnadel 2 und die von den Haltearmen 6 bis 9 ausgeübten Federkräfte auf die zu testende Leiterplatte ausgeübt werden. Da die Masse der Prüfnadel weniger als 0,1 g und vorzugsweise weniger als 70 mg beträgt ist der Impuls sehr gering und die auf die Leiterplatte ausgeübte Kraft wird im wesentlichen alleine durch die Federhärte der Haltearme bestimmt.

Diese Prüfsonde kann mit hoher Bewegungsgeschwindigkeit auf eine zu testende Leiterplatte zugeführt werden, ohne diese zu verletzen, da die Impulsübertragung sehr gering und die Federkräfte exakt definiert sind.

Vorzugsweise wird die Bewegung der Prüfsonde 1 durch das von der Lichtschranke erfasste Signal gesteuert. Wird die Prüfnadel 2 in Bewegungsrichtung 20 bewegt, so tritt die Messfahne 17 in die Lichtmessstrecke ein, was durch ein entsprechendes elektrisches Signal erfasst wird. Da das Signal proportional zum Weg der Prüfnadel 2 ist, kann anhand des Messsignales festgestellt werden, wie weit die Prüfnadel aus der Ausgangsstellung bewegt worden ist. Ab einem bestimmten Auslenkungsweg, der z.B. 1 mm beträgt, kann die Bewegung der Prüfsonde 1 abgebremst werden.

Hierdurch wird die maximale Auslenkung der Prüfnadel 2 bzgl. der Halterung 10 begrenzt, wodurch die Federkraft, die von den Haltearmen über die Prüfnadel 2 auf die Leiterplatte ausgeübt wird wiederum begrenzt wird. So kann die auf eine Leiterplatte ausgeübte Kraft sehr gering gehalten werden, selbst wenn die Prüfsonde 1 mit hoher Geschwindigkeit auf die zu testende Leiterplatte zugeführt wird, wird aufgrund des geringen übertragenen Bewegungsimpulses und der begrenzten Federkraft die Oberfläche der zu testenden Leiterplatte nicht beschädigt.

Fig. 8 zeigt schematisch vereinfacht eine Messanordnung zum Messen des elektrischen Widerstandes einer Leiterbahn 21 a einer zu testenden Leiterplatte 21. Die Leiterbahn 21 a weist an ihren Enden jeweils einen Leiterplattentestpunkt 22 auf. Auf die beiden Leiterplattentestpunkte 22 ist jeweils eine Prüfsonde 1 mit einer Prüfnadel 2 aufgesetzt. Die beiden Prüfnadeln 2 sind jeweils über Leiterbahnen 23 mit einer Stromquelle 24 verbunden. Weiterhin sind die Prüfnadeln 2 jeweils über Leiterbahnen 25 mit einem hochohmigen Spannungsmesser 26 verbunden. Diese Schaltung, die zwei Stromkreise mit einer Stromquelle und einen Spannungsmesser aufweist, wird als 4-Draht-Schaltung bezeichnet. Mit ihr kann ein Widerstand sehr präzise gemessen werden, da der durch den Spannungsmesser 26 fließende Strom äußerst gering ist. Bei der Prüfsonde 1 nach dieser Ausführungsform ist einer der beiden oberen Haltearme 6, 7 mit dem Leiter 23 und der andere mit dem Leiter 25 verbunden. Der Widerstand der zu messenden Leiterbahn 21 wird somit nur durch den Widerstand der Prüfnadeln 2 und der Übergangswiderstand zwischen den Prüfnadeln 2 und den Leiterplattentestpunkten beeinflußt.

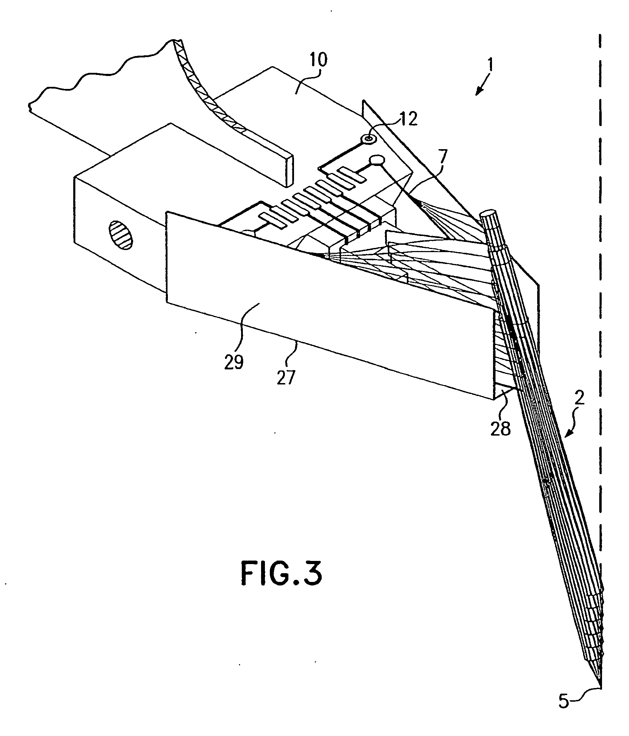

Fig. 3 und 4 zeigen eine zweite Ausführungsform, bei welcher die Haltearme 6 bis 9 innerhalb einer elektrisch leitenden Wanne 27 angeordnet sind, die die als elektrische Zuleitung fungierenden Haltearme gegenüber elektrischer Strahlung abschirmen. Diese Wanne 27 weist eine Bodenwandung 28 und zwei Seitenwandungen 29 auf.

Die Wanne 27 ist, wie die unteren Haltearme 8, 9 elektrisch mit den Stiften 12 verbunden, die auf Masse liegen. Im benachbart zur Prüfnadel 2 ist auf der Bodenwandung 28 ein Quersteg 29a angeordnet, der die Bewegung der unteren Haltearme 8, 9 nach unten begrenzt, wobei der Quersteg 29a höher angeordnet ist, als die Befestigungsstelle der unteren Haltearme 8, 9 an der Halterung 10. Hierdurch ist die Einheit aus Prüfnadel 2 und den Haltearmen 7 bis 9 gegenüber der in Fig. 1 gezeigten Ausgangsstellung ein Stück nach oben angehoben und die Haltearme 6 bis 9 stehen unter einer Vorspannung.

Diese Vorspannung dient dazu, dass bei einer schnellen Beschleunigung der Prüfsonde 1 aufgrund der bei der Beschleunigung auftretenden Kräfte die Prüfnadel 2 nicht gegenüber der Halterung 10 bewegt wird und evtl. mit ihrer Messfahne die Lichtschranke in unerwünschter Weise auslösen würde.

Im Rahmen der Erfindung ist es auch möglich, dass an Stelle einer Wanne ein rohrförmiges Abschirmelement vorgesehen wird, das die Haltearme auch nach oben hin abschirmt.

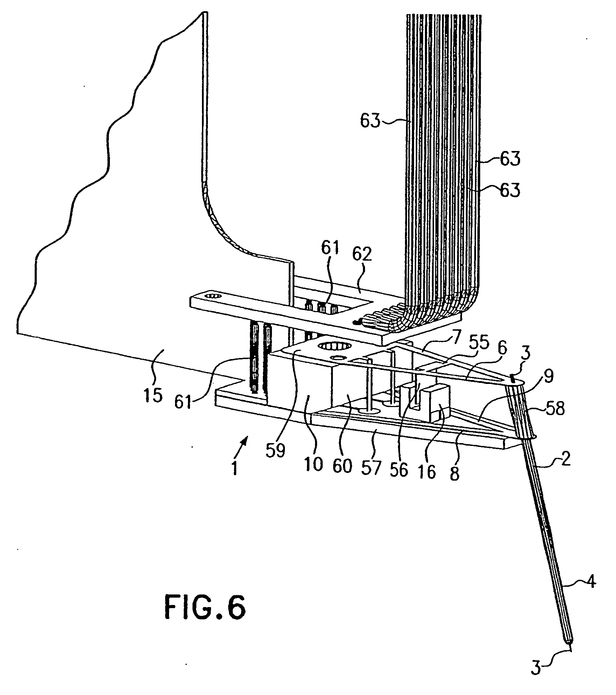

Eine dritte Ausführungsform der Prüfsonde (Fig. 5, 6) ist im wesentlichen genauso ausgebildet wie die beiden oben beschriebenen Ausführungsformen, weshalb gleiche Teile mit gleichen Bezugzeichen bezeichnet werden. Die beiden oberen Haltearme 6, 7, und die beiden unteren Haltearme 8, 9 sind jeweils durch Ätzen aus einem dünnen Kupfer/Beryllium-Blech oder Federstahl mit einer Wandstärke von ca. 50 $\mu$m bis 200$\mu$m hergestellt. Es sind alle Bleche geeignet, die eine gute elektrische Leitfähigkeit und gute elastische Eigenschaften besitzen. Die Haltearmpaare sind deshalb schmale Blechstreifen, die in der Draufsicht V-förmig angeordnet sind. Etwa längsmittig ist zwischen den oberen Haltearmen 6, 7 ein Quersteg 55 ausgebildet, an dem eine Messfahne 56 angebunden und nach unten abgewinkelt ist. Der Quersteg befindet sich an dem Ort der Haltearme, an dem die Krümmungsrichtung der Haltearme bei einer Auslenkung wechselt (= Wendepunkt) (Fig. 7).

Die Messfahne 56 weist wiederum eine Messkante (nicht gezeigt) auf, die in ein Lichtschranken-Element 16 eingreift. Diese Messkante ist jedoch horizontal ausgebildet und die Lichtquelle und der Lichtsensor sind in vertikaler Richtung erstreckend ausgebildet, so dass das Lichtschranken-Element 16 ein zur Eintauchtiefe der Messfahne 56 proportionales Signal ausgibt. Die Haltearme 6, 7 bzw. 8, 9 enden jeweils an einem Plättchen 59, das an der Halterung 10 bspw. mittels einer Klebe-, Schraub- oder Nietverbindung befestigt ist.

Die unteren Haltearme 8, 9 liegen auf einer Basisplatte 57 auf, die aus einem nicht elektrisch leitenden Material ausgebildet ist. Die Basisplatte 57 ist in der Draufsicht im Bereich von der Halterung 10 zur Prüfnadel 2 V-förmig, d.h., von der Halterung 10 zur Prüfnadel 2 spitz zulaufend ausgebildet. Die Basisplatte 57 begrenzt die Bewegung der Haltearme nach unten.

Die Prüfnadel 2 ist wie bei den beiden oben beschriebenen Ausführungsformen mit einer Nadel 3 und einer Abschirmung 4 ausgebildet und angeordnet. Im Bereich zwischen den unteren und oberen Haltearmen 8, 9 und 6, 7 weist sie eine Abstandshülse 58 auf, die aus elektrisch isolierendem Material ausgebildet ist und die Abschirmung 4 im Bereich zwischen den Haltearmen 8, 9 und 6, 7 umschließt. Die Abstandshülse 58 ist mit den Haltearmen 6, 7 und 8, 9 mechanisch verbunden, so dass die Haltearme mit ihren von der Halterung 10 entfernten Ende auf Abstand gehalten werden. Die oberen Haltearme 6, 7 sind elektrisch mit der Nadel 3 und die unteren Haltearme 8, 9 sind elektrisch mit der Abschirmung 4 verbunden.

Die Halterung 10 ist bei dieser Ausführungsform ein etwa quaderförmiger Körper, der auf der Basisplatte 57 angeordnet ist, wobei sich zwischen der Halterung 10 und der Basisplatte 57 das Plättchen der unteren Haltearme 8, 9 befindet. Die untere Kante der zur Prüfnadel 2 weisenden Wandung 60 der Halterung 10 ist abgeschrägt, so dass die unteren Haltearme 6, 7 ein Stück freigelegt sind und sich ab einem Bereich hinter der Wandung 60 frei nach oben bewegen können.

Die Basisplatte 57 steht an der von der Prüfnadel 2 abgewandten Seite ein Stück von der Halterung 10 vor. In diesem Bereich sind Kontaktstellen auf der Basisplatte 57 angeordnet, von welchen Kontaktstifte 61 nach oben führen und an einer Kontaktplatte 62 enden, an welcher elektrische Leitungen 63 befestigt sind, die mit den Kontaktstiften 61 elektrisch verbunden sind und mit welchen die Prüfsonde 1 elektrisch mit der Prüfvorrichtung verbunden ist. Die Basisplatte 57 ist in diesem Bereich auch mechanisch an die Wandung 15 des Prüfkopfes gekoppelt.

Über Leiterbahnen auf der Basisplatte 57 sind das Lichtschranken-Element 16 und die oberen Haltearme 6, 7 mit den Kontaktstiften 61 elektrisch verbunden, wobei von dem Plättchen 59 der oberen Haltearme Verbindungsstege 67 nach unten auf die Basisplatte 57 führen und an entsprechende Leiterbahnen kontaktiert sind.

In der Funktionsweise entspricht die dritte Ausführungsform der Prüfsonde den beiden oben beschriebenen Ausführungsformen.

Bei einer weiteren Ausführungsform können an Stelle einer Prüfnadel pro Prüfsonde zwei parallel nebeneinander liegende Prüfnadeln angeordnet und von den Haltearmen getragen werden, so dass eine 4-Draht-Messung ausgeführt werden kann, bei welcher dieser die Stromquelle und der die Spannungsquelle beinhaltende Stromkreis erst am Leiterplattentestpunkt 22 zusammengeführt werden.

Ein weiterer Vorteil der erfindungsgemäßen Prüfsonde ist, dass bei einer Kollision der Prüfsonden, was bei einer fehlerhaften Programmierung des Fingertesters der Fall sein kann, die Haltearme als Sollbruchstellen fungieren, wodurch lediglich das erfindungsgemäße, relativ kleine Modul der Prüfsonde 1 an einem Prüfkopf beschädigt wird, das zudem durch Anbringen einer neuen Prüfnadel und neuer Haltearme repariert werden kann.

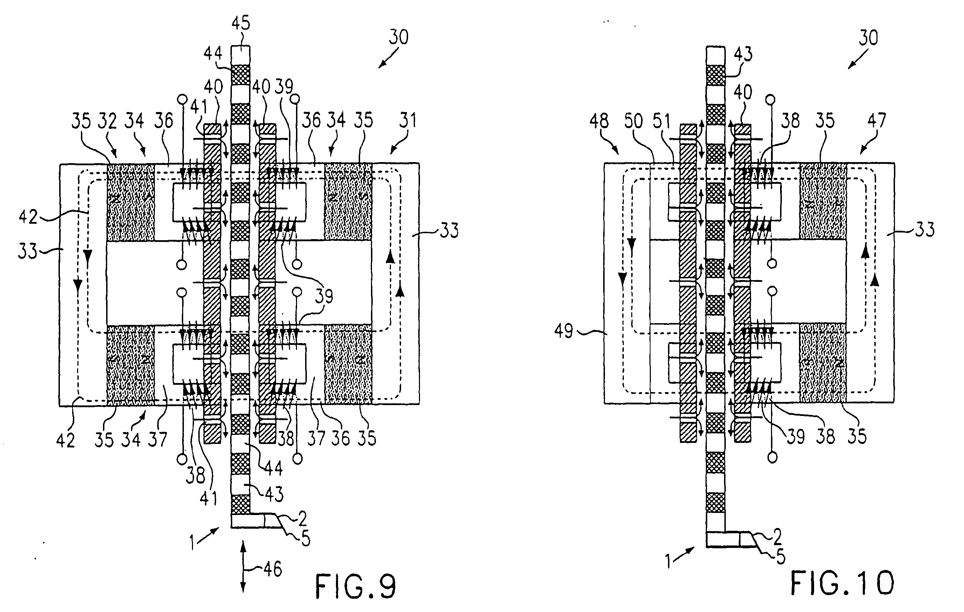

Erfindungsgemäß wird die Prüfsonde 1 von einem Linearmotor bewegt, wie er in den Figuren 9 bis 11 gezeigt ist.

Der in Figur 9 gezeigte Linearmotor 30 weist zwei in der Seitenansicht U-förmige Magnetflusskörper 31, 32 auf, die jeweils eine Basis 33 und an den Enden der Basis 33 angeordnete Schenkel 34 aufweist. Die Basis besteht jeweils aus einem weichmagnetischen Material. Die Schenkel 34 weisen jeweils angrenzend an der Basis 33 einen Permanentmagneten 35 auf. Die Permanentmagnete 35 eines Magnetflusskörpers 31, 32 sind jeweils abwechselnd mit ihrem Südpol bzw. Nordpol angrenzend an der Basis 33 angeordnet. An der von der Basis wegweisenden Seite der Permanentmagnete 35 ist jeweils ein in der Seitenansicht U-förmiger Polschuh 36 ausgebildet. Diese Polschuhe 36 weisen jeweils eine Basiswandung 37 und zwei Polwandungen 38 auf, wobei sie mit ihren Basiswandungen 37 angrenzend an den Permanentmagneten 35 angeordnet sind. Die Polwandungen sind jeweils von Antriebsspulen 39 umfasst. Jede Antriebsspule 39 erstreckt sich über zwei Polwandungen 38 eines Polschuhs 36.

Die sich jeweils über eine Polwandung 38 erstreckenden Abschnitte der Antriebsspulen sind gegenläufig gewickelt. Bei Erregung einer der Antriebsspulen 39 wird somit der von den Permanentmagneten erzeugte Magnetfluss im Bereich einer Polwandung verstärkt und im Bereich der anderen Polwandung des gleichen Polschuhes geschwächt. Vorzugsweise wird der Erregungsstrom derart eingestellt, dass der magnetische Fluss durch die Schwächung im Bereich einer der Polwandungen 38 vollständig kompensiert und im Bereich der anderen Polwandung verdoppelt wird. Bei dem in Fig. 9 gezeigten Ausführungsbeispiel sind die Antriebspulen 39 der oberen Polschuhe 36 erregt, wodurch der magnetische Fluss durch die oberen Polwandungen der beiden sich gegenüberliegenden Polschuhe 36 gebündelt wird (siehe Magnetflusslinien 42). Die Antriebspulen der unteren Polschuhe 36 sind nicht erregt, wodurch der Magnetfluss gleichmäßig auf beide Polwandungen 38 der Polschuhe 36 verteilt ist.

An den freien Enden der Polwandungen 38 der Polschuhe 36 der beiden Magnetflusskörper 31, 32 ist jeweils eine Führungsplatte 40 angeordnet, in der in regelmäßigen Abständen Luftdüsen 41 eingebracht sind. Diese Luftdüsen 41 sind derart ausgebildet, dass von der Seite, an der die Polschuhe 36 an der Führungsplatte 40 anliegen, Luft durch die Luftdüse 41 geblasen werden kann, die an der anderen Seite der Führungsplatte 40 austritt.

Die beiden Magnetflusskörper 31, 32 sind mit ihren Führungsplatten 40 derart einander gegenüberliegend angeordnet, dass die Permanentmagnete 35 mit den Polen der Permanentmagnete 35 alternierend angeordnet sind, so dass die Magnetflusslinien 42 durch beide Magnetflusskörper 31, 32 verlaufen.

Die Führungsplatten 40 der beiden Magnetflusskörper 31, 32 sind mit einem vorbestimmten Abstand D parallel zueinander angeordnet.

Zwischen den beiden Führungsplatten 40 befindet sich eine Ankerplatte 43, die aus einem nicht magnetischen Material, wie zum Beispiel Keramik, Kunststoff oder einem nicht-magnetischen Metall (z.B. Aluminium oder Kupfer), ausgebildet ist. In diese Ankerplatte 43 sind in regelmäßigen Abständen d streifenförmige Ankerelemente 45 eingesetzt, die aus einem magnetischen Material, wie zum Beispiel Eisen, bestehen. Der Abstand d zwischen zwei benachbarten Ankerelementen 45 wird derart gewählt, dass gilt:

- Befindet sich ein Ankerelement 45 im Bereich zwischen zwei Polwandungen 38 zweier gegenüberliegender Polschuhe 36, so ist im Bereich zwischen den beiden anderen Polwandungen 38 der gleichen Polschuhe 36 ein aus nicht magnetischem Material 44 bestehender Abschnitt der Ankerplatte 43 angeordnet, und
- zwischen den Paaren von Polwandungen 38 der weiteren Polschuhe 36 des Linearmotors 30 befinden sich jeweils Grenzbereiche zwischen Ankerelementen 45 und Abschnitten aus nicht magnetischem Material.

An einem Ende der Ankerplatte 45 ist die erfindungsgemäße Prüfsonde 1 befestigt.

Nachfolgend wird die Funktionsweise dieses Linearmotors 30 näher erläutert.

Im Betrieb wird aus den Luftdüsen 41 auf die Ankerplatte 43 Luft geblasen, wodurch die Ankerplatte 43 auf Abstand zu den Führungsplatten 40 gehalten wird, so dass keine mechanische Reibung zwischen der Ankerplatte 43 und den Führungsplatten 40 auftritt. Hierbei wird die Luft mit einem Druck von ca. 2 - 6 bar eingeblasen, wodurch Luftkissen mit einer Dicke von ca. 5 - 10 $\mu$m erzeugt werden. Diese Luftkissen sind selbstzentrierend, d.h., sollte die Ankerplatte 43 durch äußere Einflüsse gegen eine der beiden Führungsplatten gedrückt werden, so nimmt durch den sich verringernden Abstand die Kraft zu, um den ursprünglichen Abstand wieder herzustellen.

Die Ankerspulen 39 der Magnetflusskörper 31, 32 werden abwechselnd angeregt. Hierdurch wird der Magnetfluss der Permanentmagnete 35 in einer Polwandung 38 eines Polschuhes 36 konzentriert und in der anderen Polwandung 38 des Polschuhes verringert. In Fig. 9 sind die Antriebsspulen 39 der beiden oberen Polschuhe angeregt, so dass der Magnetfluss durch die oberen Polwandungen konzentriert ist. Die Antriebsspulen der unteren Polschuhe 36 sind nicht angeregt, weshalb die Magnetflusslinien 42 gleichmäßig auf die beiden Polwandungen 38 verteilt sind.

In den Bereich der sich gegenüberliegenden Polwandungen 38, durch welche der Magnetfluss konzentriert ist, wird jeweils das nächstliegende Ankerelement 45 gezogen, wodurch die Ankerplatte 43 in Bewegungsrichtung 46 (nach unten oder oben) bewegt wird. Durch Ansteuerung der Antriebsspulen 39 mit einem Sinuskurven entsprechenden Verlauf des Anregungsstromes kann die Ankerplatte 43 gleichmäßig nach unten oder oben bewegt werden, wobei die beiden Antriebsspulen jeweils eines der Magnetflusskörper 31, 32 mit einem Phasenversatz von 90° angesteuert werden. Die gegenüberliegend angeordneten Antriebsspulen werden synchron angesteuert. Diese Art der Ansteuerung entspricht derjenigen bekannter Linearmotoren.

Das Prinzip eines Linearmotors gemäß der vorliegenden Erfindung liegt darin, dass die Ankerplatte mit ihren entlang einer vorbestimmten Richtung linear angeordneten Ankerelementen 45 durch geschickte magnetische Ansteuerung über einen mehrere Ankerelemente umfassenden Bereich bewegt und innerhalb dieses Bereiches an mehreren Stellen gehalten werden kann, wobei der Abstand dieser Haltestellen üblicherweise dem halben Abstand zweier benachbarter Ankerelemente entspricht.

Ein wesentlicher Vorteil des erfindungsgemäßen Linearmotors liegt darin, dass die Ankerplatte 43 sehr leicht ausgebildet ist. Bei einem Prototypen des erfindungsgemäßen Linearmotors beträgt das Gewicht der Ankerplatte 10 g. Diese Ankerplatte besteht aus einer Keramikplatte, in der aus einem Weicheisenmaterial bestehende Ankerelemente eingelegt sind.

Durch das geringe Gewicht der Ankerplatte und der erfindungsgemäßen Prüfsonde 1 können diese mit geringen Kräften schnell beschleunigt und abgebremst werden. Da zudem keine mechanische Reibung bei der Bewegung der Ankerplatte auftritt, sind die auftretenden Bewegungskräfte sehr gering. Dies erlaubt eine sehr schnelle Kontaktierung der zu testenden Leiterplattentestpunkte, wobei durch die geringe Bewegungskräfte die Gefahr einer Beschädigung der Leiterplatte sehr gering ist. Mit dem Prototypen der vorliegenden Erfindung wurde eine Beschleunigung und eine Verzögerung von ca. 800 m/s$^2$ erzielt.

Figur 10 zeigt eine vereinfachte Ausführungsform des in Figur 9 gezeigten Linearmotors, bei welchem wiederum zwei Magnetflusskörper 47, 48 vorgesehen sind, wobei der Magnetflusskörper 47 identisch zu dem Magnetflusskörper 31 aus Figur 9 ausgebildet ist, weshalb gleiche Teile mit gleichem Bezugszeichen bezeichnet sind.

Der Magnetflusskörper 48 besteht lediglich aus einer Basis 49 und zwei Schenkeln 50. Die Basis 49 und die Schenkel 50 sind aus einem magnetischen Material ausgebildet. Der Magnetflusskörper 48 ist in der Seitenansicht U-förmig ausgebildet. Die einzelnen Schenkel 50 sind wiederum in der Seitenansicht U-förmig mit Polwandungen 51 ausgebildet, die zu den Polwandungen 38 des Magnetflusskörpers 48 jeweils paarweise gegenüberliegend angeordnet sind. Der Magnetflusskörper 48 weist wiederum eine Führungsplatte 40 mit Luftdüsen 41 auf, die an den freien Enden der Polwandungen 51 angebracht ist.

Der Magnetflusskörper 48 bildet somit einen passiven Magnetflusskörper gegenüber dem aktiven Magnetflusskörper 47.

Die in Figur 10 gezeigte Ausführungsform des Linearmotors ist wesentlich einfacher und kostengünstiger als die in Figur 9 gezeigte Ausführungsform ausgebildet.

Figur 11 zeigt eine dritte Ausführungsform eines Linearmotors. Dieser weist wiederum zwei Magnetflusskörper 52, 53 auf. Der Magnetflusskörper 53 ist identisch zu dem passiven Magnetflusskörper 48 aus Figur 10 ausgebildet. Gleiche Teile sind deshalb mit gleichen Bezugszeichen bezeichnet. Der Magnetflusskörper 52 weist im Wesentlichen die gleiche Bauform wie der Magnetflusskörper 53 mit einer Basis 49 und zwei als Polschuhe ausgebildete Schenkel 50 auf, wobei jeder Polschuh zwei Polwandungen 51 aufweist. Lediglich die Polwandungen 51 sind etwas länger, da daran die Antriebsspulen 39 zum Antreiben der Ankerplatte 43 vorgesehen sind. Anstelle der Permanentmagnete der oben beschriebenen Ausführungsformen ist eine Spule 54 um die Basis 49 des Magnetflusskörpers 52 angeordnet, mit welcher ein statisches Magnetfeld an die Magnetflusskörper 52, 53 angelegt wird. Mit dem Betrag des statischen Magnetfeldes kann die Kraft, mit welcher die Ankerplatte 43 gehalten wird, eingestellt werden. Dieses statische Magnetfeld ist deshalb variabel ausgebildet. Die Änderungsraten, mit welchen das statische Magnetfeld verändert wird, sind jedoch wesentlich geringer als die Änderungsraten der von den Antriebsspulen 39 erzeugten Magnetfelder, die mit hoher Frequenz ein- und ausgeschaltet bzw. umgepolt werden.

Da durch das Anregen der Antriebsspulen das statische Magnetfeld auf die Polwandungen 38 in der oben anhand der Ausführungsform gemäß Fig. 9 beschriebenen Art und Weise konzentriert wird, kann durch Variieren des statischen Magnetfeldes auch die Kraft, mit welcher die Ankerplatte bewegt wird, dosiert werden. Es kann somit eine sehr sanfte Kontaktierung bewerkstelligt werden, so dass mit diesem Linearmotor auch grundsätzlich eine Prüfsonde mit einer nicht gefederten Prüfnadel verwendet werden kann.

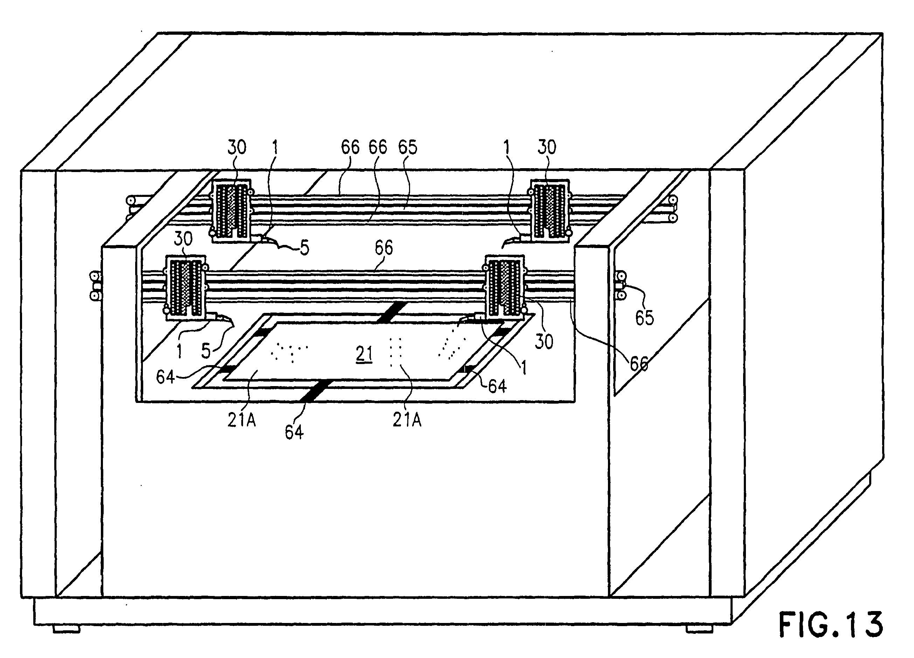

Fig. 13 zeigt schematisch eine Prüfvorrichtung zum Testen von unbestückten Leiterplatten 21, die ein Fingertester ist. Der Fingertester weist mehrere Prüfköpfe 68 auf, die jeweils aus einer erfindungsgemäßen Prüfsonde 1 und einem der oben beschriebenen Linearmotoren 30 ausgebildet sind.

Der Fingertester besitzt einen Bereich zur Aufnahme der zu testenden Leiterplatte 21, die mittels Halteelementen 64 gehalten wird. Im Bereich oberhalb dieses Aufnahmebereichs ist zumindest eine Traverse 65 angeordnet, die sich über diesen Aufnahmebereich erstreckt. Vorzugsweise sind es mehrere Traversen 65, die feststehend oder auch beweglich am Fingertester ausgebildet sind. Sind die Traversen 65 ortsfest an dem Fingertester angeordnet, so sind die Prüfköpfe mit einer Schwenkeinrichtung versehen, mit welcher zumindest die jeweilige Prüfsonde 1 um eine vertikale Achse geschwenkt werden kann.

Jeder der Prüfköpfe 68 ist jeweils an einen Förderriemen 66 gekoppelt, mit welchen er automatisch entlang der jeweiligen Traverse 65 verfahrbar ist. An einer Traverse sind vorzugsweise zwei Prüfköpfe 68 angeordnet, so dass an den Traversen 65 jeweils zwei Förderriemen 66 angeordnet sind.

Im Betrieb werden die Prüfsonden 1 mit ihren Prüfspitzen 5 durch eine Bewegung in der Ebene parallel zur Leiterplatte 21 über einen zu testenden Leiterplattentestpunkt 21 a positioniert. Danach wird die Kontaktspitze auf den Leiterplattentestpunkt 21 a mittels des Linearmotors 30 abgesenkt, bis die Prüfspitze 5 den Leiterplattentestpunkt kontaktiert. Hieran schließt sich die elektrische Messung an, nach der die Prüfsonde wieder angehoben und zum nächsten Leiterplattentestpunkt verfahren wird.

Mit den erfindungsgemäßen Linearmotoren sind Beschleunigungen bis zu 80g erzielt worden.

Mit dem erfindungsgemäßen Fingertester kann die Vertikalbewegung mit hoher Geschwindigkeit (z.B. 1,5 m/s) ausgeführt werden, wobei geringste mechanische Impulse auf die Leiterplattentestpunkte ausgeübt werden. In Tests hat sich gezeigt, bei welchen an Stelle von Leiterplatten dünne Kunststofffolien aus weichen Kunststoffmaterialen, wie z.B. FA4, Epoxifolie, usw. in den Fingertester eingelegt worden sind, keine Kontaktabdrücke durch die Prüfspitzen auf der Folie hinterlassen worden sind, obwohl die Prüfsonden mit maximaler Geschwindigkeit auf die Folie zu bewegt worden sind.

Der in Fig. 13 gezeigte Fingertester weist Prüfköpfe nur einer Seite der zu testenden Leiterplatte 21 auf. Im Rahmen der Erfindung ist es selbstverständlich möglich den Fingertester mit Prüfköpfen, Traversen, etc. auf beiden Seiten der zu testenden Leiterplatte auszubilden.

Bezugszeichenliste

| | |
|---|---|
| 1 | Prüfsonde |
| 2 | Prüfnadel |
| 3 | Nadel |
| 4 | Abschirmung |
| 5 | Prüfspitze |
| 6 | Haltearm |
| 7 | Haltearm |
| 8 | Haltearm |
| 9 | Haltearm |
| 10 | Halterung |
| 11 | Kontaktfläche |
| 12 | Stift |
| 13 | Schlitz |
| 14 | Bohrung |
| 15 | Wandung des Prüfkopfs |
| 16 | Lichtschranken-Element |
| 16a | Basis |
| 16b | Schenkel |
| 17 | Messfahne |
| 18 | Messkante |
| 19 | Bewegungsrichtung beim Kontaktieren |
| 20 | Bewegungsrichtung |
| 21 | Leiterplatte |
| 21 a | Leiterbahn |
| 22 | Leiterplattentestpunkt |
| 23 | Leiter |
| 24 | Stromquelle |
| 25 | Leiter |
| 26 | Spannungsmesser |
| 27 | Wanne |
| 28 | Bodenwandung |
| 29 | Seitenwandung |
| 29a | Quersteg |
| 30 | Linearmotor |
| 31 | Magnetflusskörper |
| 32 | Magnetflusskörper |
| 33 | Basis |
| 34 | Schenkel |
| 35 | Permanentmagnet |
| 36 | Polschuh |
| 37 | Basiswandung |
| 38 | Polwandung |
| 39 | Antriebsspule |
| 40 | Führungsplatte |
| 41 | Luftdüse |
| 42 | Magnetflusslinie |
| 43 | Ankerplatte |
| 44 | nicht magnetisches Material |
| 45 | Ankerelement |
| 46 | Bewegungsrichtung |
| 47 | Magnetflusskörper |

| | |
|---|---|
| 48 | Magnetflusskörper |
| 49 | Basis |
| 50 | Schenkel |
| 51 | Polwandung |
| 52 | Magnetflusskörper |
| 53 | Magnetflusskörper |
| 54 | Spule |
| 55 | Quersteg |
| 56 | Messfahne |
| 57 | Basisplatte |
| 58 | Abstandshülse |
| 59 | Plättchen |
| 60 | Wandung |
| 61 | Kontaktstift |
| 62 | Kontaktplatte |
| 63 | Leitung |
| 64 | Halteelement |
| 65 | Traverse |
| 66 | Förderriemen |
| 67 | Verbindungssteg |
| 68 | Prüfkopf |

**Patentansprüche**

1. Fingertester zum Testen von unbestückten Leiterplatten umfassend

   einen Linearmotor mit zwei einander gegenüberliegend angeordneten, statischen Magnetflusskörpern (31, 32; 47, 48; 52, 53) und einer dazwischen angeordneten, beweglichen Ankerplatte (43), die aus einem nicht-magnetischen Material ausgebildet ist und in regelmäßigen Abständen streifenförmige Ankerelemente (45) aufweist, die aus einem magnetischen Material ausgebildet sind,

   wobei an der Ankerplatte (43) eine Prüfsonde (1), die keinen eigenen Antrieb aufweist, mit einer Prüfnadel, die mit einer Prüfspitze mit einem Leiterplattentestpunkt in Kontakt bringbar ist, und mittels zumindest zweier elastisch federnder Haltearme schwenkbar an einer Halterung befestigt ist, angeordnet ist,

   und zumindest einer der Haltearme aus einem elektrisch leitenden Material ausgebildet und mit der Prüfnadel elektrisch verbunden ist.

2. Fingertester nach Anspruch 1,
   **dadurch gekennzeichnet,**
   **dass** die Prüfsonde (1) zwei Paar Haltearme aufweist,

   die jeweils in einer Ebene angeordnet und mit einem Ende an der Prüfnadel und mit dem anderen Ende an der Halterung befestigt sind und in der Draufsicht jeweils ein Dreieck aufspannen.

3. Fingertester nach Anspruch 2,
   **dadurch gekennzeichnet,**
   **dass** beide Paare Haltearme einen aus einem elektrisch leitenden Material ausgebildeten Haltearm aufweisen und mit der Prüfnadel elektrisch verbunden sind.

4. Fingertester nach einem der Ansprüche 1 bis 3,
   **dadurch gekennzeichnet,**
   **dass** die Prüfnadel von einer Abschirmung umgeben ist, die elektrisch mit einem elektrisch leitenden und auf Masse geschalteten Haltearm verbunden ist.

5. Fingertester nach einem der Ansprüche 1 bis 4,
   **dadurch gekennzeichnet,**
   **dass** die Haltearme in der Seitenansicht die Form eines Trapezes aufspannen.

6. Fingertester nach Anspruch 5,
   **dadurch gekennzeichnet,**

**dass** der bzw. die näher an der Prüfspitze angeordneten Haltearm(e) länger als der bzw. die von der Prüfspitze weiter entfernt angeordnete(n) Haltearm(e) ist(sind).

7. Fingertester nach Anspruch 6,
   **dadurch gekennzeichnet,**
   **dass** die Länge der von der Prüfspitze weiter entfernt angeordneten Haltearme (6, 7) in der Seitenansicht mit der Variable a, die Länge der näher an der Prüfspitze angeordneten Haltearme (8, 9) mit der Variable b, die Länge der Prüfnadel (2) mit der Variable L und die Länge des Abschnittes der Prüfnadel 2 zwischen den jeweiligen Haltearmen mit der Variable $L_0$ bezeichnet werden und diese Längenangaben folgende Relation erfüllen:

$$a \approx b\left(1 - \tan\frac{L_0}{L}\right)$$

8. Fingertester nach einem der Ansprüche 1 bis 7,
   **dadurch gekennzeichnet,**
   **dass** die Haltearme zumindest bereichsweise von einem Abschirmelement umgeben sind.

9. Fingertester nach einem der Ansprüche 1 bis 8,
   **dadurch gekennzeichnet,**
   **dass** ein Vorspannelement (29a) vorgesehen ist, das die Haltearme entgegen der Kontaktierungsrichtung um einen bestimmten Betrag vorspannt.

10. Fingertester nach einem der Ansprüche 1 bis 9,
    **dadurch gekennzeichnet,**
    **dass** ein Positionssensor zum Bestimmen der Position der Prüfnadel gegenüber der Halterung vorgesehen ist.

11. Fingertester nach Anspruch 10,
    **dadurch gekennzeichnet,**
    **dass** der Positionssensor eine an der Halterung ausgebildete Lichtschranke mit einer Lichtmessstrecke und eine an der Prüfnadel angeordnete Fahne zum Unterbrechen der Lichtmessstrecke aufweist.

12. Fingertester nach Anspruch 11,
    **dadurch gekennzeichnet,**
    **dass** die Lichtmessstrecke eine vorbestimmte Ausdehnung etwa quer zur Bewegungsrichtung der Prüfnadel aufweist und die Fahne eine Unterbrechungskante aufweist, die schräg zur Ausdehnungsrichtung der Lichtmessstrecke verläuft.

13. Fingertester nach einem der Ansprüche 1 bis 12,
    **dadurch gekennzeichnet,**
    **dass** zumindest einer der Magnetflusskörper (31, 32; 47) zumindest einen Permanentmagneten aufweist und an den zur Ankerplatte (43) weisenden Endbereichen mehrere Polwandungen (38) aufweist, auf welchen Antriebsspulen (39) angeordnet sind.

14. Fingertester nach einem der Ansprüche 1 bis 12,
    **dadurch gekennzeichnet,**
    **dass** zumindest einer der Magnetflusskörper (52) zumindest einen Spule (54) zum Erzeugen eines statischen Magnetfeldes aufweist und an den zur Ankerplatte (43) weisenden Endbereichen mehrere Polwandungen (38) aufweist, auf welchen Antriebsspulen (39) angeordnet sind.

15. Fingertester nach einem der Ansprüche 1 bis 14,
    **dadurch gekennzeichnet,**
    **dass** an beiden Magnetflusskörpern (31, 32; 47, 48; 52, 53) Luftdüsen vorgesehen sind, die jeweils auf die Ankerplatte zum Ausbilden eines Luftkissens zwischen der Ankerplatte (43) und den Magnetflusskörpern (31, 32; 47, 48; 52, 53) gerichtet sind.

**Claims**

1. Finger tester for the testing of non-componented circuit boards comprising
   a linear motor with two static magnetic flux elements (31, 32; 47, 48; 52, 53) arranged opposite one another, and an armature plate (43) mounted movably between them and made of a non-magnetic material and having at regular intervals strip-shaped armature elements (45) made of a magnetic material,
   wherein a test probe (1) is mounted on the armature plate (43), with no independent drive, with a test needle with a probe tip which may be brought into contact with a circuit board test point, and which may be pivotally attached to a mount by means of at least two flexible sprung retaining arms,
   and at least one of the retaining arms is made of an electrically conductive material and is electrically connected to the test needle.

2. Finger tester according to claim 1,
   **characterised in that**
   the test probe (1) has two pairs of retaining arms wherein each is mounted in one plane, with one end fixed to the test needle and the other end to the mount, and spanning a triangle when viewed from above.

3. Finger tester according to claim 2,
   **characterised in that**
   both pairs of retaining arms comprise a retaining arm made of an electrically conductive material and are electrically connected to the test needle.

4. Finger tester according to any of claims 1 to 3,
   **characterised in that**
   the test needle is surrounded by a shield which is electrically connected to a retaining arm which is electrically conductive and connected to earth.

5. Finger tester according to any of claims 1 to 4,
   **characterised in that**
   the retaining arms span the shape of a trapezium when viewed from the side.

6. Finger tester according to claim 5,
   **characterised in that**
   the retaining arm or arms which is or are closer to the probe tip is or are longer than the retaining arm(s) which is or are further away from the probe tip.

7. Finger tester according to claim 6,
   **characterised in that**
   the length of the retaining arms (6, 7) further away from the probe tip viewed from the side is designated by the variable a, the length of the retaining arms (8, 9) closer to the probe tip by the variable b, the length of the test needle (2) by the variable L, and the length of the section of the test needle (2) between the respective retaining arms by the variable $L_0$, and these length details satisfy the following relationship:

$$a \approx b\left(1 - \tan\frac{L_0}{L}\right)$$

8. Finger tester according to any of claims 1 to 7,
   **characterised in that**
   the retaining arms are surrounded, at least in part, by a shield element.

9. Finger tester according to any of claims 1 to 8,
   **characterised in that**
   a pre-tensioning element (29a) is provided, to pre-tension the retaining arms against the direction of contacting by a specific amount.

EP 1 542 023 B1

**10.** Finger tester according to any of claims 1 to 9,
**characterised in that**
a position sensor is provided to determine the position of the test needle relative to the mount.

**11.** Finger tester according to claim 10,
**characterised in that**
the position sensor has a photoelectric switch with an optical measuring section provided on the mount, and a vane to interrupt the optical measuring section provided on the test needle.

**12.** Finger tester according to claim 11,
**characterised in that**
the optical measuring section has a predetermined extent roughly at right-angles to the direction of movement of the test needle, and the vane has an interrupting edge running at an angle to the direction in which the optical measuring section extends.

**13.** Finger tester according to any of claims 1 to 12,
**characterised in that**
at least one of the magnetic flux elements (31, 32; 47) has one or more permanent magnets and, on the end sections facing the armature plate (43), has several pole walls (38) on which driving coils (39) are mounted.

**14.** Finger tester according to any of claims 1 to 12,
**characterised in that**
one or more of the magnetic flux elements (52) has at least one coil (54) for generating a static magnetic field and, on the end sections facing the armature plate (43), has several pole walls (38) on which driving coils (39) are mounted.

**15.** Finger tester according to any of claims 1 to 14,
**characterised in that**
on both magnetic flux elements (31, 32; 47, 48; 52, 53) there are provided air nozzles, each directed on to the armature plate to form an air cushion between the armature plate (43) and the magnetic flux elements (31, 32; 47, 48; 52, 53).

**Revendications**

**1.** Testeur à doigt destiné à contrôler des cartes à circuits imprimés non équipées, comportant un moteur linéaire avec deux corps statiques à flux magnétique (31, 32 ; 47, 48 ; 52, 53) agencés en vis-à-vis l'un de l'autre, et une plaque formant induit (43) mobile interposée entre ceux-ci qui est réalisée d'un matériau non magnétique et qui comprend à des distances régulières des éléments d'induit (45) en forme de lame réalisés d'un matériau magnétique,
dans lequel sur la plaque formant induit (43) est agencée une sonde de test (1), qui ne comprend pas de propre entraînement, comportant une aiguille de test qui est susceptible d'être amenée en contact par une pointe de test avec un point de test de la carte à circuits imprimés, et qui est fixée sur une monture avec faculté de pivotement au moyen d'au moins deux bras de retenue élastiques à effet ressort, et
l'un au moins des bras de retenue est réalisé d'un matériau électriquement conducteur et est connecté électriquement à l'aiguille de test.

**2.** Testeur à doigt selon la revendication 1, **caractérisé en ce que** la sonde de test (1) comprend deux paires de bras de retenue qui sont agencés dans un plan respectif et qui sont fixés par une extrémité sur l'aiguille de test et par l'autre extrémité sur la monture, et **en ce que**, vus de dessus, chaque paire de bras de retenue définit une forme triangulaire.

**3.** Testeur à doigt selon la revendication 2, **caractérisé en ce que** les deux paires de bras de retenue comprennent un bras de retenue réalisé en un matériau électriquement conducteur, et sont reliées électriquement à l'aiguille de test.

**4.** Testeur à doigt selon l'une des revendications 1 à 3, **caractérisé en ce que** l'aiguille de test est entourée par un blindage qui est connecté électriquement à un bras de maintien électriquement conducteur et branché à la masse.

**5.** Testeur à doigt selon l'une des revendications 1 à 4, **caractérisé en ce que**, vus de côté, les bras de retenue définissent une forme trapézoïdale.

14

**6.** Testeur à doigt selon la revendication 5, **caractérisé en ce que** le ou les bras de retenue agencé(s) plus près de la pointe de test est/sont plus long(s) que le ou les bras de retenue agencé(s) plus éloigné(s) de la pointe de test.

**7.** Testeur à doigt selon la revendication 6, **caractérisé en ce que**, vue de côté, la longueur des bras de retenue (6, 7) agencés plus éloignés de l'aiguille de test est désignée par la variable a, la longueur des bras de retenue (8, 9) agencés plus près de la pointe de test est désignée par la variable b, la longueur de l'aiguille de test (2) est désignée par la variable L et la longueur de la portion de l'aiguille de test (2) entre les bras de retenue respectifs est désignée par la variable $L_0$, et ces valeurs de longueur satisfont la relation suivante :

$$a \approx b\left(1 - \tan\frac{Lo}{L}\right)$$

**8.** Testeur à doigt selon l'une des revendications 1 à 7, **caractérisé en ce que** les bras de retenue sont entourés au moins localement par un élément de blindage.

**9.** Testeur à doigt selon l'une des revendications 1 à 8, **caractérisé en ce qu'**il est prévu un élément de précontrainte (29a) qui met sous précontrainte les bras de retenue d'une valeur déterminée en sens inverse à la direction de mise en contact.

**10.** Testeur à doigt selon l'une des revendications 1 à 9, **caractérisé en ce qu'**il est prévu un détecteur de position pour déterminer la position de l'aiguille de test par rapport à la monture.

**11.** Testeur à doigt selon la revendication 10, **caractérisé en ce que** le détecteur de position comprend une barrière lumineuse réalisée sur la monture et présentant un trajet photométrique et un drapeau agencé sur l'aiguille de test pour interrompre le trajet photométrique.

**12.** Testeur à doigt selon la revendication 11, **caractérisé en ce que** le trajet photométrique présente une extension prédéterminée approximativement transversalement à la direction de mouvement de l'aiguille de test, et **en ce que** le drapeau présente une arête d'interruption qui s'étend en oblique par rapport à la direction d'extension du trajet photométrique.

**13.** Testeur à doigt selon l'une des revendications 1 à 12, **caractérisé en ce que** l'un au moins des corps à flux magnétique (31, 32 ; 47) comprend au moins un aimant permanent et plusieurs parois polaires (38) dans les zones d'extrémité dirigées vers la plaque formant induit (43), parois sur lesquelles sont agencées des bobines d'excitation (39).

**14.** Testeur à doigt selon l'une des revendications 1 à 12, **caractérisé en ce que** l'un au moins des corps à flux magnétique (52) comprend au moins une bobine (54) pour générer un champ magnétique statique et plusieurs parois polaires (38) dans les zones d'extrémité dirigées vers la plaque formant induit (43), parois sur lesquelles sont agencées des bobines d'excitation (39).

**15.** Testeur à doigt selon l'une des revendications 1 à 14, **caractérisé en ce que** des buses à air sont prévues sur les deux corps à flux magnétique (31, 32 ; 47, 48 ; 52, 53), qui sont dirigées chacune vers la plaque formant induit pour réaliser un coussin d'air entre la plaque formant induit (43) et les corps à flux magnétique (31, 32 ; 47, 48 ; 52, 53).

FIG.1

FIG.2

FIG.3

FIG.4

FIG.5

FIG.6

FIG.7

FIG.8

FIG.9

FIG.10

EP 1 542 023 B1

FIG.12

FIG.11

FIG.13

EP 1 542 023 B1